# EUROPEAN PATENT APPLICATION

(11) **EP 4 601 007 A2**
(43) Date of publication of application: **13.08.2025**
(21) Application number: 25151542.5
(22) Date of filing: 13.01.2025
(51) Int. Cl.: H01L 23/58

(54) **SEMICONDUCTOR DEVICE WITH A GUARD RING STRUCTURE**

(30) Priority: 08.02.2024 KR 20240019645; 05.03.2024 KR 20240031616; 02.07.2024 KR 20240086929
(71) Applicant: Samsung Electronics Co., Ltd., Suwon-si, Gyeonggi-do 16677 (KR)
(72) Inventor: HAN, Minchul, 16677 Suwon-si (KR); KIM, Inho, 16677 Suwon-si (KR); SCHMIDT, Alexander, 16677 Suwon-si (KR); KWAK, Euna, 16677 Suwon-si (KR); KWON, Ohhun, 16677 Suwon-si (KR); KWON, Hyuckjoon, 16677 Suwon-si (KR); PARK, Chuntaek, 16677 Suwon-si (KR); YEOM, Kyungmi, 16677 Suwon-si (KR); LEE, Daehee, 16677 Suwon-si (KR); LEE, Injae, 16677 Suwon-si (KR); LEE, Jaeeun, 16677 Suwon-si (KR); CHOI, Jungyun, 16677 Suwon-si (KR)
(74) Representative: Marks & Clerk LLP

(57) **Abstract**

A semiconductor device includes a semiconductor substrate including a device region and an edge region surrounding the device region, an interconnection structure including a plurality of conductive pattern layers stacked on the device region in a vertical direction, a guard ring structure extending in a horizontal direction to surround the interconnection structure within the edge region, a crack blocking structure disposed outside the guard ring structure, pad structures disposed on the interconnection structure, and a passivation layer disposed on the pad structures, wherein each of the plurality of blocking pattern layers extends to surround at least a portion of the outside of the guard ring structure.

## Description

### BACKGROUND

As demand for high performance, high speed, and/or multifunctionality for semiconductor devices has increased, the degree of integration of semiconductor devices has increased. In manufacturing fine-patterned semiconductor devices in response to the trend of high integration of semiconductor devices, it is required to implement patterns with a fine width or a fine distance. In addition, high integration of semiconductor devices mounted on semiconductor packages is required.

### SUMMARY

In general, in some aspect, the present disclosure is directed toward a semiconductor device having improved reliability.

In general, according to some aspects, a semiconductor device includes a semiconductor substrate including a device region and an edge region surrounding the device region, an interconnection structure including a plurality of conductive pattern layers stacked on the device region in a vertical direction, a guard ring structure extending in a horizontal direction to surround the interconnection structure within the edge region, an crack blocking structure disposed outside the guard ring structure and including a plurality of blocking pattern layers stacked in the vertical direction, pad structures disposed on the interconnection structure and electrically connected to at least a portion of the plurality of conductive pattern layers, and a passivation layer disposed on the pad structures and including an opening exposing at least a portion of the pad structures, wherein each of the plurality of blocking pattern layers extends to surround at least a portion of the outside of the guard ring structure and includes a plurality of first through-holes arranged in the horizontal direction and having substantially the same planar shape.

According to some aspects of the present disclosure, a semiconductor device includes a semiconductor substrate including a device region and an edge region surrounding the device region, a plurality of conductive pattern layers stacked on the device region in a vertical direction, a guard ring structure extending in a horizontal direction to surround the device region, and a plurality of blocking pattern layers disposed on the edge region around the guard ring structure and stacked in the vertical direction, wherein at least a portion of the plurality of conductive pattern layers and the plurality of blocking pattern layers are adjacent to each other in the vertical direction and include mesh pattern layers each having a plurality of through-holes.

According to some aspects of the present disclosure, a semiconductor device includes a semiconductor substrate including a device region in which integrated circuit devices are disposed and an edge region surrounding the device region, a plurality of interconnection pattern layers stacked on the device region in a vertical direction and electrically connected to the integrated circuit devices, a plurality of dummy pattern layers stacked on the device region in the vertical direction and electrically insulated from the plurality of interconnection pattern layers, and a plurality of crack blocking pattern layers stacked on the edge region in the vertical direction and extending in a horizontal direction to surround the device region, wherein each of the plurality of crack blocking pattern layers is a mesh pattern including a plurality of first through-holes, and at least a portion of the plurality of interconnection pattern layers are mesh patterns including a plurality of second through-holes.

At least some of the above and other features of the invention are set out in the claims.

### BRIEF DESCRIPTION OF DRAWINGS

Example implementations will be more clearly understood from the following detailed description, taken in conjunctions with the accompanying drawings.
FIG. 1 is a plan view of a semiconductor substrate including an example of a semiconductor device according to example embodiments.
FIG. 2 is a partially enlarged view of an example of a region 'A' in FIG. 1 according to example embodiments.
FIG. 3A is a cross-sectional view taken along line I-I' of FIG. 2 and FIG. 3B is a cross-sectional view illustrating an example of a portion of a semiconductor device according to example embodiments.
FIGS. 4A to 4C are perspective views illustrating an example of a vertical arrangement of mesh pattern layers according to example embodiments.
FIGS. 5A to 5F are plan views illustrating an example of a planar shape of mesh patterns according to example embodiments.
FIG. 6 is a plan view of an example of a semiconductor device according to example embodiments.
FIG. 7 is a plan view of an example of a semiconductor device according to example embodiments.
FIG. 8 is a plan view of an example of a partial region of a semiconductor device according to example embodiments.
FIG. 9 is a plan view of an example of a partial region of a semiconductor device according to example embodiments.
FIG. 10 is a plan view of an example of a partial region of a semiconductor device according to example embodiments.
FIG. 11 is a plan view of an example of a partial region of a semiconductor device according to example embodiments.
FIG. 12A is a perspective view illustrating a guard ring structure of an example embodiment, and FIG. 12B is a plan view of a portion of the guard ring structure of FIG. 12A.
FIG. 13 is a plan view of a semiconductor device according to an example embodiment.
FIG. 14 is a plan view of a semiconductor device according to an example embodiment.
FIG. 15 is a plan view of a semiconductor device according to an example embodiment.
FIG. 16 is a plan view of a semiconductor device according to an example embodiment.
FIG. 17 is a plan view of a semiconductor device according to an example embodiment.
FIG. 18 is a plan view of a semiconductor device according to an example embodiment.
FIG. 19A is a cross-sectional view of an example of a semiconductor package including a semiconductor device according to example embodiments, and FIG. 19B is a partially enlarged view of an example of a region 'B' of FIG. 19A according to example embodiments.
FIG. 20 is a cross-sectional view of an example of a semiconductor package including a semiconductor device according to example embodiments.

### DETAILED DESCRIPTION

Hereinafter, example implementations will be described in detail with reference to the accompanying drawings. Unless otherwise specified, in this specification, terms, such as `upper portion', `upper surface', `lower portion', `lower surface', `side surface', etc. are based on the drawings, and may vary used in the directions in which components are actually arranged. The terms "upper", "middle", "lower" may refer to relative positions along a particular direction (e.g. a vertical direction). Various directions (e.g. vertical direction, horizontal direction, etc.) may be defined relative to the structure of the devices described herein. For instance, a vertical direction may be defined perpendicular to an upper surface of a semiconductor substrate. Similarly, a horizontal direction may be defined parallel to the upper surface of the semiconductor substrate. It will be appreciated that these directions do not necessarily imply any particular orientation of the device in use.

In addition, ordinal numbers, such as "first," "second," "third," etc., may be used as labels for specific elements, steps, directions, etc. to distinguish various elements, steps, directions, etc. from each other. Terms that are not described using "first," "second," etc. in the specification may still be referred to as "first" or "second" in the claims. In addition, terms referenced by a particular ordinal number (e.g., "first" in a particular claim) may be described elsewhere with a different ordinal number (e.g., "second" in the specification or other claims).

As used herein, the singular forms "a", "an", and "the" are intended to include the plural forms as well, unless the context clearly indicates otherwise. Additionally, the description may be specific to a portion of the semiconductor device and the described structure may be repeated in other portions of the semiconductor device. For example, the described structure may be an individual element of an array of elements forming the semiconductor device. Accordingly, where the structure of a single element of a plurality of elements has been described, this structure may equally apply to other elements of the plurality of elements.

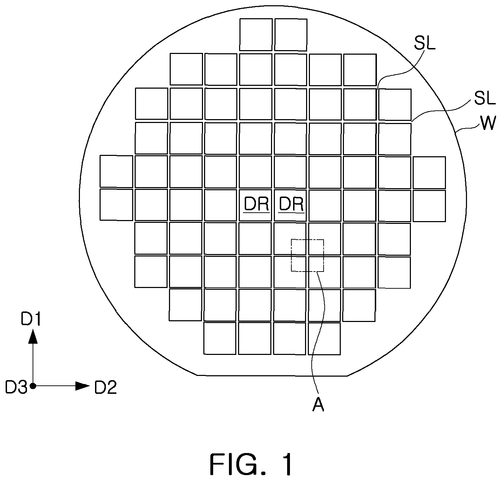

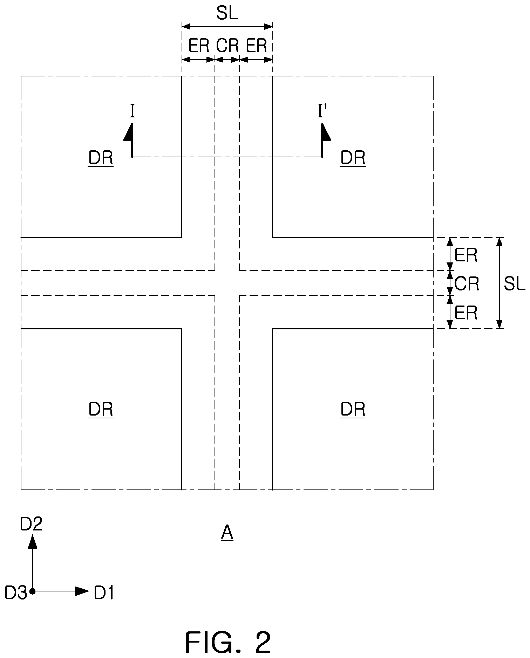

FIG. 1 is a plan view of an example of a semiconductor substrate including a semiconductor device according to example embodiments. FIG. 2 is a partially enlarged view of an example of a region 'A' in FIG. 1 according to example embodiments.

In FIGS. 1 and 2, a semiconductor substrate W may include device regions DR and a scribe line region SL between the device regions DR. The scribe line region SL may form a grid shape. The scribe line region SL may include lines extending in a first horizontal direction D1 and lines extending in a second horizontal direction D2 intersecting the first horizontal direction D1. The device regions DR may be arranged to be spaced apart from each other in the first horizontal direction D1 and the second horizontal direction D2 and may be surrounded by the scribe line regions SL. The device regions DR may be separated along the scribe line region SL through a dicing process to be described below to form a semiconductor device. The scribe line region SL may include a cut region CR cut by a sawing or dicing machine and edge regions ER between the cut region CR and the device regions DR. The edge regions ER may surround the device regions DR, respectively.

In example embodiments, one or more of the device regions DR may be provided with a volatile memory device, such as dynamic random access memory (DRAM) or static random access memory (SRAM), or a nonvolatile memory device, such as phase-change random access memory (PRAM), magnetoresistive random access memory (MRAM), ferroelectric random access memory (FeRAM), or resistive random access memory (RRAM). In an example embodiment, a logic device, such as a microprocessor, an analog device, or a digital signal processor may be provided in the device region DR.

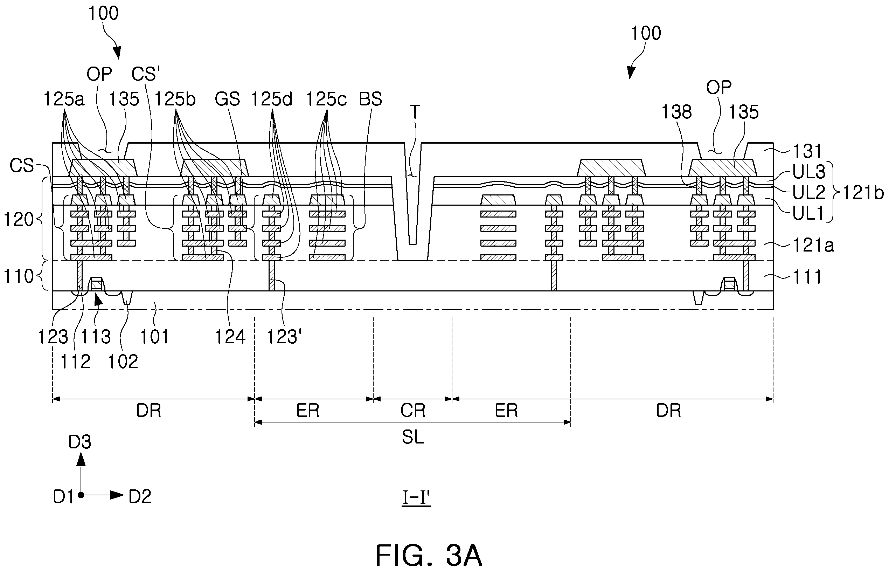

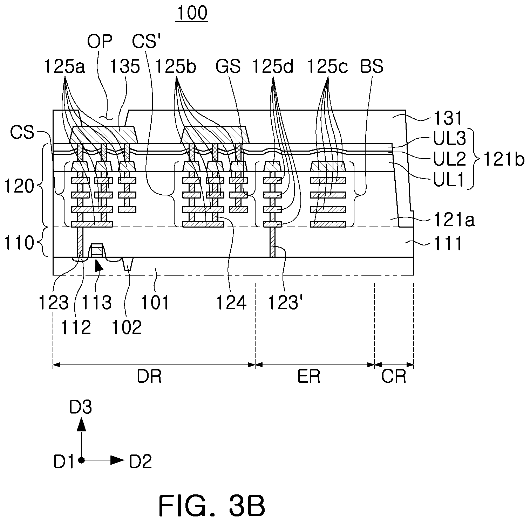

FIG. 3A is a cross-sectional view taken along line I-I' of FIG. 2 according to example embodiments, and FIG. 3B is a cross-sectional view illustrating an example of a portion of a semiconductor device 100 according to example embodiments.

In FIGS. 3A and 3B, the semiconductor device 100 may include a semiconductor substrate 101, a device layer 110, and an interconnection layer 120. The semiconductor substrate 101 may correspond to the semiconductor substrate W illustrated in FIG. 1.

The semiconductor substrate 101 may include the device regions DR and the scribe line region SL between the device regions DR. The scribe line region SL may include the edge regions ER and the cut region CR between the edge regions ER. Each edge region ER may surround a corresponding device region DR. The cut region CR may refer to a portion separated during a dicing process to be described below. The semiconductor substrate 101 may include a semiconductor material. For example, the semiconductor substrate 101 may be a silicon substrate, germanium substrate, silicon germanium substrate, or silicon-on-insulator (SOI) substrate. The semiconductor substrate 101 may include a semiconductor material, such as a group IV semiconductor, a group III-V compound semiconductor, or a group II-VI compound semiconductor. The semiconductor substrate 101 may include a conductive region 112 and an isolation region 102. The conductive region 112 may be, for example, a well doped with impurities or a structure doped with impurities. The isolation region 102 is a device isolation structure having a shallow trench isolation (STI) structure and may include silicon oxide.

The device layer 110 may include a lower insulating layer 111 and integrated circuit (IC) devices 113. The lower insulating layer 111 may cover the semiconductor substrate 101 and the IC devices 113. The lower insulating layer 111 may include silicon oxide, silicon nitride, silicon oxynitride, or combinations thereof. For example, the lower insulating layer 111 may include silicon oxide. The IC devices 113 may be disposed in the device regions DR. The IC devices 113 may include a memory cell array including a switching element and a data storage element and logic elements including a MOSFET, a capacitor, and a resistor. The IC devices 113 may include, for example, a field-effect transistor (FET), such as a planar FET and a FinFET, memory devices, such as flash memory, DRAM, SRAM, electrically erasable programmable read-only memory (EEPROM), PRAM, MRAM, FeRAM, and RRAM, logic devices, such as AND, OR, NOT, etc., various active and/or passive elements, such as, system large-scale integration (LSI), complementary metal-insulator-semiconductor imaging sensor (CIS), and micro-electromechanical system (MEMS).

Whilst the semiconductor device 100 includes a plurality of device regions DR, the features of these device regions DR may be substantially the same. Accordingly, the arrangement of a single device region DR is described in the following sections. Nevertheless, it will be appreciate that this arrangement may apply equally to other device regions DR.

The interconnection layer 120 may be formed on the device layer 110. The interconnection layer 120 may include a plurality of conductive pattern layers 125a, 125b, and 125c arranged on different levels in a vertical direction, and an interlayer insulating layer 121a and an upper insulating layer 121b covering the plurality of conductive pattern layers 125a, 125b, and 125c. The plurality of conductive pattern layers 125a, 125b, and 125c may include interconnection pattern layers 125a and dummy pattern layers 125b disposed in the device region DR and crack blocking pattern layers (or `blocking pattern layers') 125c arranged in the edge region ER. In some example embodiments, at least a portion of the blocking pattern layers 125c may also be disposed in the cut region CR. The plurality of conductive pattern layers 125a, 125b, and 125c aligned in the vertical direction may form an interconnection structure CS, a dummy interconnection structure CS', and a crack blocking structure BS, respectively, to be described below.

The interlayer insulating layer 121a surrounds the plurality of conductive pattern layers 125a, 125b, and 125c and may include a low-k material. A low-k material may have a low dielectric constant. A low dielectric constant may be a dielectric constant that is less than that of silicon dioxide. The interlayer insulating layer 121a may include silicon oxide or organic polymer doped with impurities. In example embodiments, the interlayer insulating layer 121a may include SiOCH, SiCN, or combinations thereof. The interlayer insulating layer 121a may include a plurality of insulating layers sequentially stacked on the lower insulating layer 111. However, depending on the process, the boundaries between interlayer insulating layers may not be apparent. The uppermost interlayer insulating layer 121a (e.g., a portion covering the uppermost conductive pattern layer) among the interlayer insulating layers 121a may include a material different from one or more interlayer insulating layers 121a therebelow. For example, the uppermost interlayer insulating layer 121a may include silicon oxide.

The upper insulating layer 121b may include a first upper insulating layer UL1, a second upper insulating layer UL2, and a third upper insulating layer UL3. In example embodiments, a portion of the second upper insulating layer UL2 overlapping the uppermost pattern layers 125a, 125b, and 125c in the vertical direction may protrude upwardly. The second upper insulating layer UL2 may include a material having etch selectivity with respect to the first upper insulating layer UL1. For example, the first upper insulating layer UL1 may include high density plasma (HDP) oxide. The second upper insulating layer UL2 may include silicon nitride, silicon oxynitride, silicon carbonitride, or combinations thereof. In an example embodiment, the third upper insulating layer UL3 may include silicon oxide. For example, the third upper insulating layer UL3 may include tetraethyl orthosilicate (TEOS).

The plurality of conductive pattern layers 125a, 125b, and 125c include copper (Cu), aluminum (Al), tungsten (W), nickel (Ni), titanium (Ti), titanium nitride (TiN), tantalum (Ta), tantalum nitride (TaN), gold (Au), or combinations thereof. For example, the uppermost pattern layers may include aluminum (Al), and the pattern layers therebelow may include copper (Cu). At least a portion of the conductive pattern layers 125a, 125b, and 125c may include a plurality of patterns spaced apart from each other in the horizontal direction. In the present disclosure, a `pattern layer' may be understood as generally referring to 'patterns' arranged on the same level. The 'patterns' may include an interconnection extending in the horizontal direction and a pad connected to the interconnection. At least a portion of the plurality of conductive pattern layers 125a, 125b, and 125c may be connected in a vertical direction through vias 124.

The interconnection structure CS may include a plurality of interconnection pattern layers 125a stacked in the vertical direction on the device region DR. The interconnection structure CS may be electrically connected to the conductive region 112 and/or at least one IC device 113 by an interconnector 123 (e.g., a contact plug).

The dummy interconnection structure CS' may include a plurality of dummy pattern layers 125b stacked in the vertical direction. The dummy interconnection structure CS' may be electrically insulated from the interconnection structure CS. The dummy interconnection structure CS' may be electrically insulated from the interconnection structure integrated circuit (IC) device(s) 113. In the present context, the term "dummy" may refer to a structure that does not directly affect the electrical performance of the device (e.g. is electrically insulated from the active components of the device). A dummy structure may serve other functions, such as to provide structural support for various features during manufacture, or to provide electrical shielding to various components of the device.

The crack blocking structure BS may be disposed in the edge region ER. The crack blocking structure BS may extend in the horizontal direction to surround an outer portion of the device region DR. The crack blocking structure BS may include a plurality of blocking pattern layers 125c stacked in the vertical direction. The plurality of blocking pattern layers 125c may be electrically insulated from each other by the interlayer insulating layer 121a. According to other embodiments, the plurality of blocking pattern layers 125c may be connected to each other by the vias 124. The crack blocking structure BS may be disposed outside a guard ring structure GS. The crack blocking structure BS may be formed to continuously or discontinuously surround the guard ring structure GS on a plane.

According to example embodiments, the interconnection layer 120 may further include the guard ring structure GS between the interconnection structure CS and the crack blocking structure BS. The guard ring structure GS may be formed to surround the device region DR. For example, the guard ring structure GS may extend in the horizontal direction (e.g. to extend along a horizontal plane) to surround the interconnection structure CS within the edge region ER. The guard ring structure GS may include guard ring pattern layers 125d stacked in the vertical direction and/or guard ring via layers 124' connecting the guard ring pattern layers 125d. The guard ring pattern layers 125d may include the same material as the plurality of conductive pattern layers 125a, 125b, and 125c corresponding in the horizontal direction. In example embodiments, the guard ring structure GS may further include a dummy connection portion 123' connected to an upper surface of the semiconductor substrate 101. The guard ring structure GS may prevent cracks from propagating toward or moisture from absorbing to the interior of the device region DR.

A passivation layer 131 and an upper conductive pattern (or `pad structure') 135 may be formed on the interconnection layer 120. The upper conductive pattern 135 may be connected to the dummy interconnection structure CS' and the interconnection structure CS through conductive vias 138. The upper conductive pattern 135 may include multiple conductive structures that are respectively connected to one of the dummy interconnection structure CS' and the interconnection structure CS. The conductive structure (e.g. a dummy pad) connected to the dummy interconnection stricture CS' may be electrically insulated from the conductive structure connected to the interconnection structure CS. The conductive vias 138 may vertically penetrate through the second upper insulating layer UL2 and the third upper insulating layer UL3. The upper conductive pattern 135 and the conductive via 138 may include the same material, but are not limited thereto.

The passivation layer 131 may include a single-layer or multilayer insulating film. For example, the passivation layer 131 may include an oxide film and/or a nitride film. The passivation layer 131 may include an opening OP exposing at least a portion of the upper conductive pattern 135.

The upper conductive pattern 135 may include, for example, a ground pad, a power pad, an AC pad, a data pad, a dummy pad and a DC pad. The ground pad may be a pad for providing a reference potential for a circuit operation of the semiconductor device 100. The power pad may be a pad for supplying power for the circuit operation. The AC pad may be a pad supplying AC power to the semiconductor device 100 or receiving a signal for performing an AC test. The data pad may be a pad for input/output of logic signals or data. The DC pad may be a pad for measuring a potential level at a specific position of the semiconductor device 100. A dummy pad may be connected to the dummy interconnection structure CS'. The dummy pad may be covered by the passivation layer 131.

The semiconductor device 100 may be separated by cutting the cut region CR in which a trench T is formed through a dicing process. The trench T may extend in the horizontal direction (e.g. along the horizontal plane) to surround the device region DR and the edge region ER. In some example embodiments, the trench T may not completely cut the interconnection layer 120.

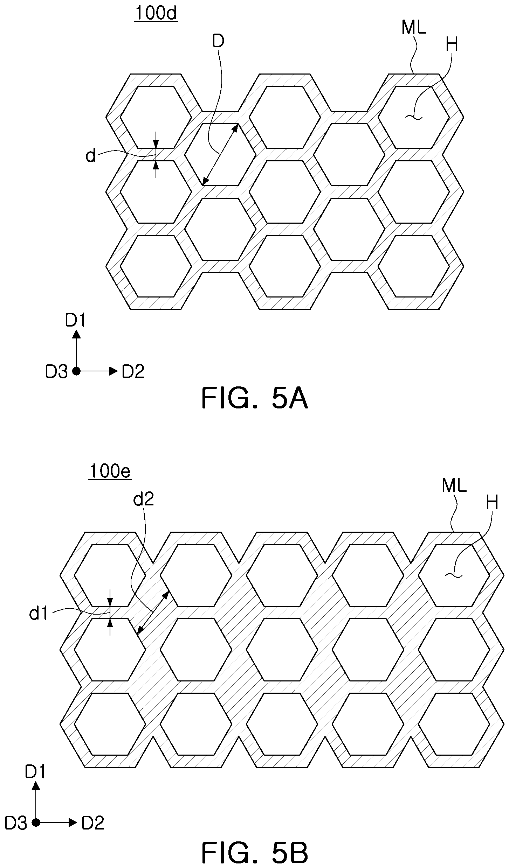

According to example embodiments, at least a portion of the pattern layers inside the semiconductor device 100, for example, the plurality of conductive pattern layers 125a, 125b, and 125c, may include a mesh pattern. Some of the pattern layers respectively constituting the interconnection structure CS, the dummy structure CS', and the crack blocking structure BS may include mesh pattern layers or mesh patterns adjacent to each other in the vertical direction D3 and having a plurality of through-holes. Alternatively, it may include a mesh pattern. The plurality of through-holes may have a circular or polygonal planar shape (see FIGS. 5A to 5F).

In example embodiments, the mesh patterns or mesh structure may be applied without distinguishing between a regular pattern and an irregular pattern in a layout design stage of the semiconductor device 100. Accordingly, the reliability of the semiconductor device 100 may be improved by applying the mesh pattern layer without distinguishing between the device region DR and the edge region ER. For example, the mesh pattern layer applied to the crack blocking structure BS may prevent stress propagating from the cut region CR and prevent the occurrence and propagation of cracks. In addition, the mesh pattern layer applied to the interconnection structure CS and the dummy interconnection structure CS' may distribute stress occurring inside the device region DR and prevent the occurrence and propagation of cracks. By arranging the mesh pattern layers of example embodiments in the vertical direction, a vertical component of stress may be effectively distributed.

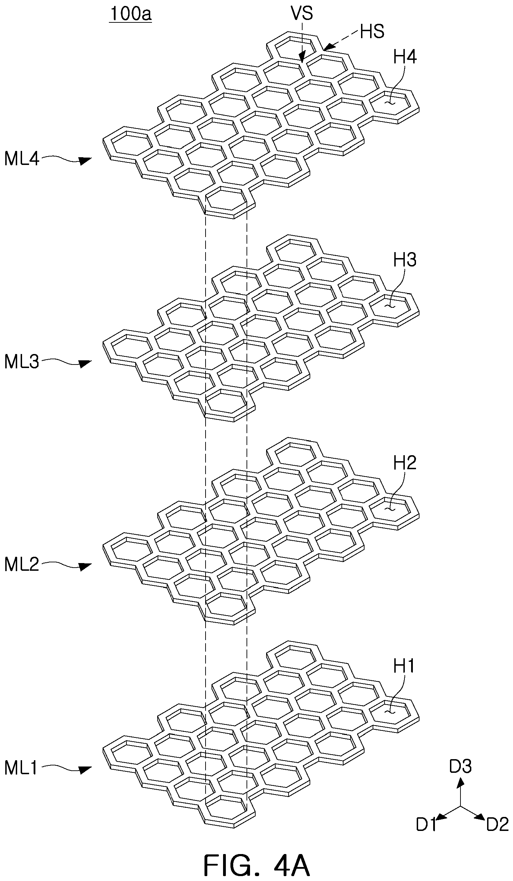

Hereinafter, a mesh pattern layer may be applied to example embodiments, as described below with reference to FIGS. 4A to 4C and 5A to 5F.

FIGS. 4A to 4C are perspective views illustrating examples of vertical arrangement of mesh pattern layers ML1, ML2, ML3, and ML4 according to example embodiments. In FIG. 4A, a semiconductor device 100a may include a plurality of mesh pattern layers (or `mesh patterns') ML1, ML2, ML3, and ML4 aligned in the vertical direction D3. The semiconductor device 100a may include a first mesh pattern ML1, a second mesh pattern ML2, a third mesh pattern ML3, and a fourth mesh pattern ML4. In an example embodiment, first holes H1 of the first mesh pattern ML1, second holes H2 of the second mesh pattern ML2, third holes H3 of the third mesh pattern ML3, and fourth holes H4 of the fourth mesh pattern ML4 may be aligned to completely overlap in the vertical direction. The plurality of mesh patterns ML1, ML2, ML3, and ML4 may extend to define closed loop-shaped holes H1, H2, H3, and H4, thereby effectively distributing a horizontal component HS of stress. In addition, by arranging the plurality of mesh patterns ML1, ML2, ML3, and ML4 in the vertical direction D3, the vertical component VS of stress may be effectively distributed. In addition, the plurality of mesh patterns ML1, ML2, ML3, and ML4 have bent borders, so that the stress transmitted from the outside of each pattern may be more effectively relieved.

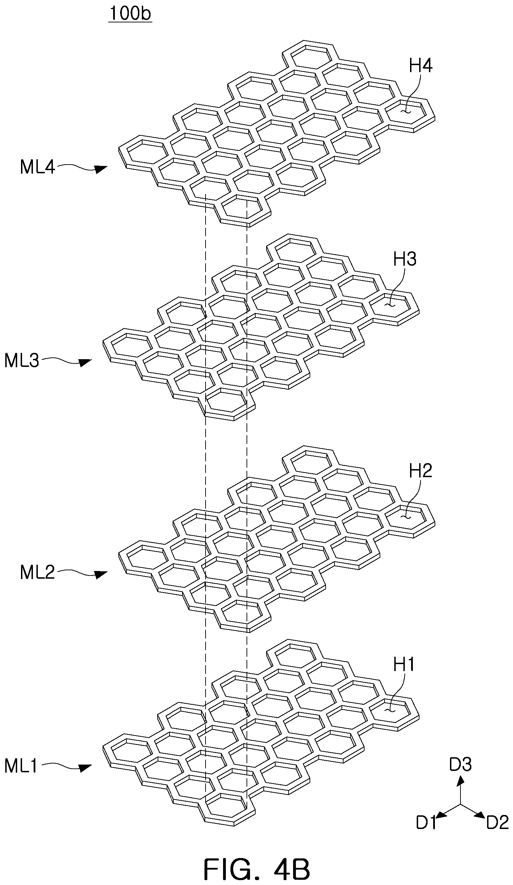

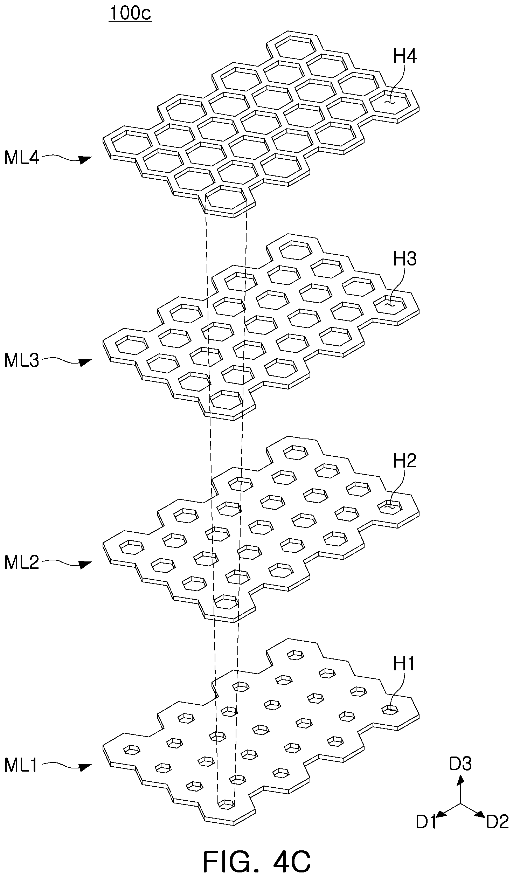

The plurality of mesh patterns ML1, ML2, ML3, and ML4 may be understood as pattern layers included in at least one of the interconnection structure CS, the dummy interconnection structure CS', and the crack blocking structure BS of FIGS. 3A and 3B. The plurality of interconnection pattern layers 125a, the plurality of dummy pattern layers 125b, and/or the plurality of blocking pattern layers 125c may partially or fully include a region in which the mesh pattern layers ML1, ML2, ML3, and ML4 illustrated in FIG. 4A and FIGS. 4B and 4C described below are aligned in the vertical direction. For example, the mesh pattern layers ML1, ML2, ML3, and ML4 illustrated in FIG. 4A may be understood as respectively corresponding to the lower four layers among the plurality of blocking pattern layers 125c illustrated in FIG. 3B but are not limited thereto. In addition, the plurality of mesh patterns ML1, ML2, ML3, and ML4 need not be arranged at equal intervals in the vertical direction, and in some example embodiments, a non-mesh pattern may be disposed between the plurality of mesh patterns ML1, ML2, ML3, and ML4. The plurality of mesh patterns ML1, ML2, ML3, and ML4 may have different thicknesses.

In FIG. 4B, a semiconductor device 100b may include a plurality of mesh patterns ML1, ML2, ML3, and ML4 arranged to be staggered in the horizontal direction (e.g., D2). In example embodiments, the first holes H1 of the first mesh pattern ML1, the second holes H2 of the second mesh pattern ML2, the third holes H3 of the third mesh pattern ML3, and the fourth holes H4 of the fourth mesh pattern ML4 may partially overlap. For example, the second holes H2 of the second mesh pattern ML2 may partially overlap the first holes H1 and third holes H3 adjacent to each other in the vertical direction.

In FIG. 4C, a semiconductor device 100c may include a plurality of mesh patterns ML1, ML2, ML3, and ML4 having through-holes of different sizes. For example, the first holes H1 of the first mesh pattern ML1, the second holes H2 of the second mesh pattern ML2, the third mesh pattern H3 of the third mesh pattern ML3, and the fourth holes H4 of the fourth mesh pattern ML4 located on different levels in the vertical direction may have different sizes (e.g., planar area, width, etc.). The planar area of each of the first holes H1 may be less than the planar area of each of the second holes H2, the third holes H3, and the fourth holes H4. The planar area of each of the second holes H2 may be less than the planar area of each of the third holes H3 and the fourth holes H4. The planar area of each of the third holes H3 may be less than the planar area of each of the fourth holes H4. In the drawing, the sizes of the plurality of holes H1, H2, H3, and H4 are illustrated to sequentially decrease toward lower levels, but are not limited thereto.

However, in example embodiments, through-holes located on the same level in the horizontal direction may have substantially the same size. For example, the first holes H1 of the first mesh pattern ML1 may have the same size. The second holes H2 of the second mesh pattern ML2 may have the same size. The third holes H3 of the third mesh pattern ML3 may have the same size. The fourth holes H4 of the fourth mesh pattern ML4 may have the same size. Here, the 'same' includes process errors, process margins, etc., and means that the sizes were not intentionally designed to be different.

FIGS. 5A to 5F are plan views illustrating examples of planar shapes of the mesh patterns ML according to example embodiments. In FIG. 5A, in a semiconductor device 100d, a mesh pattern ML may have hexagonal through-holes H. The through-holes H formed in one mesh pattern ML may have substantially the same planar shape. The through-holes H may be arranged to partially overlap with the through-holes H adjacent thereto in the horizontal direction(s). For example, the mesh pattern ML may be formed in a honeycomb structure. The mesh pattern ML may extend with a substantially uniform line width d and may define a spacing between adjacent through-holes H. The spacing d between adjacent through-holes H may be equal to or smaller than the maximum width D of each of the through-holes H. The maximum width D of each of the through-holes H may be about 1 µm or less (e.g. may be 1 µm or less).

In FIG. 5B, in a semiconductor device 100e, the mesh pattern ML may have hexagonal through-holes H. The through-holes H may be arranged to entirely overlap the through-holes H adjacent thereto in the horizontal direction(s). The mesh pattern ML may include portions with different line widths. For example, the mesh pattern ML may include a first portion having a first line width d1 and a second portion having a second line width d2 greater than the first line width d1. As such, in the mesh pattern ML applied to example embodiments, the spacings between adjacent through-holes H may not be constant.

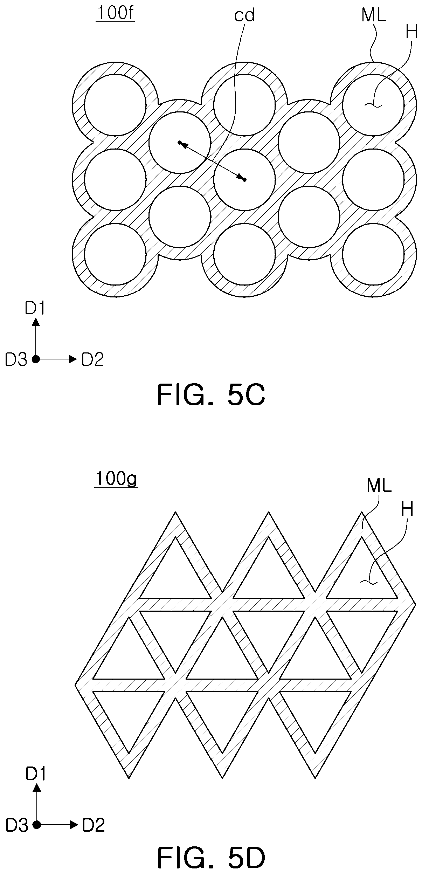

In FIG. 5C, in a semiconductor device 100f, the mesh pattern ML may have circular through-holes H. The through-holes H may be arranged to at least partially overlap the through-holes H adjacent thereto in the horizontal direction. The distance cd between the centers of adjacent circular through-holes H may be substantially equal. In some example embodiments, the spacings between adjacent through-holes H may not be constant.

In FIG. 5D, in a semiconductor device 100g, the mesh pattern ML may have triangular through-holes H. The through-holes H may be arranged to at least partially overlap the through-holes H adjacent thereto in the horizontal direction(s).

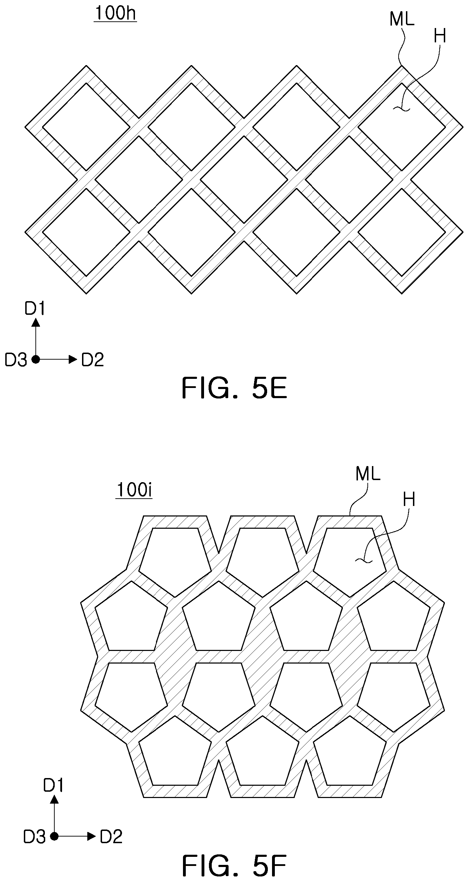

In FIG. 5E, in a semiconductor device 100h, the mesh pattern ML may have square through-holes H. The through-holes H may be arranged to at least partially overlap the through-holes H adjacent thereto in the horizontal direction(s). In some example embodiments, the through-holes H may have a planar shape, such as a rectangle, trapezoid, or diamond.

In FIG. 5F, in a semiconductor device 100i, the mesh pattern ML may have pentagonal through-holes H. The through-holes H may have substantially the same planar shape and size (e.g., planar area, width, etc.). The through-holes H may be arranged to at least partially overlap the through-holes H adjacent thereto in the horizontal direction(s).

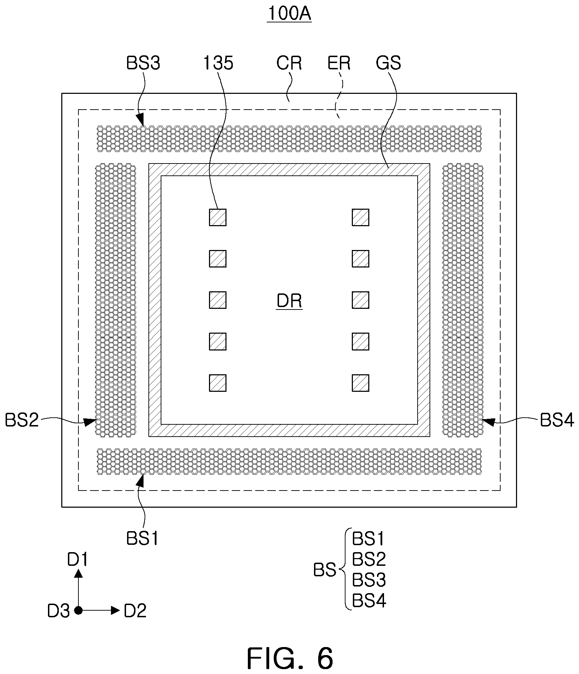

FIG. 6 is a plan view of an example of a semiconductor device according to example embodiments. In FIG. 6, a semiconductor device 100A may include a crack blocking structure BS including a plurality of blocking patterns BS1, BS2, BS3, and BS4. The plurality of blocking patterns BS1, BS2, BS3, and BS4 may have a structure the same as or similar to the mesh patterns described above with reference to FIGS. 4A to 5F. The semiconductor device 100A may partially include a cut region CR remaining from the dicing process and surrounding the outside of the crack blocking structure BS. The crack blocking structure BS may include a first blocking pattern BS 1, a second blocking pattern BS2, a third blocking pattern BS3, and a fourth blocking pattern BS4 respectively corresponding to the outer surfaces of the guard ring structure GS. The guard ring structure GS may extend in the horizontal direction to surround the device region DR. In the drawing, the guard ring structure GS is illustrated as a square, but is not limited thereto. In example embodiments, the guard ring structure GS may have a circular or oval planar shape. The planar shape of the crack blocking structure BS illustrated in the drawing may be understood as reflecting the shape of the blocking pattern layers 125c of FIGS. 3A and 3B. For example, each of the blocking pattern layers 125c may include the plurality of blocking patterns (e.g., BS1, BS2, BS3, and BS4) extending to surround at least a portion of the outside of the guard ring structure GS on a plane.

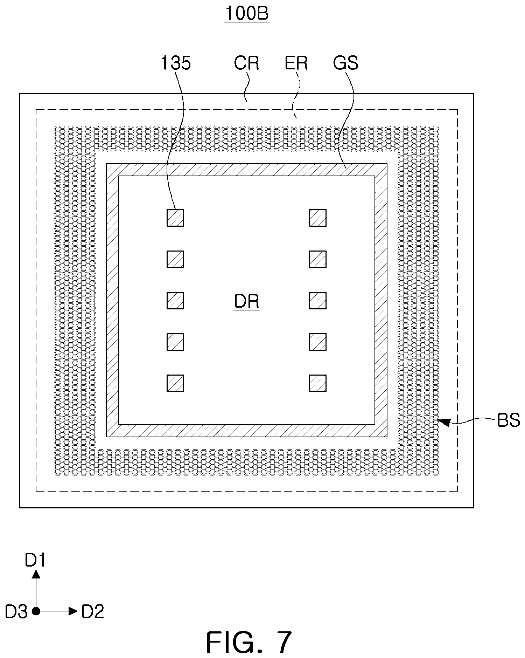

FIG. 7 is a plan view of an example of a semiconductor device according to example embodiments. In FIG. 7, a semiconductor device 100B may include a crack blocking structure BS extending integrally on a plane. The crack blocking structure BS may be formed by a blocking pattern having a structure the same as or similar to the mesh patterns described above with reference to FIGS. 4A to 5F. The crack blocking structure BS may extend in the horizontal direction(s) (e.g. in the horizontal plane) to continuously surround the guard ring structure GS. The planar shape of the crack blocking structure BS illustrated in the drawing may be understood as reflecting the shape of the blocking pattern layers 125c of FIGS. 3A and 3B. For example, each of the blocking pattern layers 125c may extend to completely surround the outside of the guard ring structure GS on a plane.

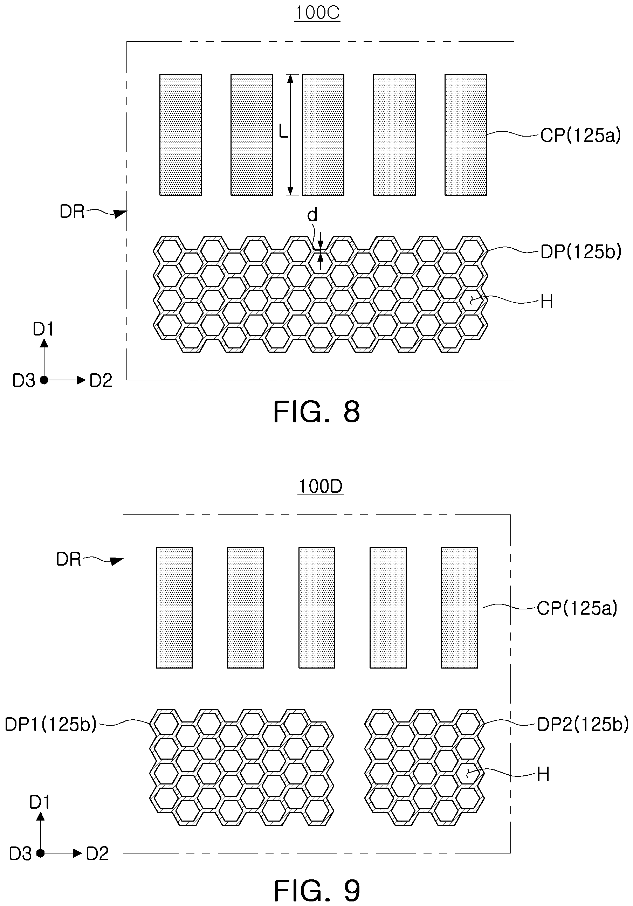

FIG. 8 is a plan view of an example of a partial region of a semiconductor device according to example embodiments. In FIG. 8, a semiconductor device 100C may include a mesh pattern disposed in the device region DR. In example embodiments, at least a portion of the interconnection pattern layer 125a may include rectangular interconnection patterns CP extending in the first direction D1 on a plane, and at least a portion of the dummy pattern layer 125b may include at least one dummy pattern DP having a plurality of through-holes H adjacent to the rectangular interconnection patterns P in the first direction D1 and arranged in the second direction D2, perpendicular to the first direction D1, on a plane. A line width d of portions of at least one dummy pattern DP, overlapping the rectangular interconnection patterns CP in the first direction D1 and defining the plurality of through-holes H, may be less than a length L of the corresponding rectangular interconnection patterns CP in the first direction D1.

The mesh dummy pattern DP may reduce warpage and improve the reliability of the semiconductor device 100D by reducing the volume of a material (e.g., metal) with a high thermal expansion coefficient in the length direction of the rectangular interconnection patterns CP.

FIG. 9 is a plan view of an example of a partial region of a semiconductor device according to example embodiments. In FIG. 9, a semiconductor device 100D may include a plurality of dummy patterns DP1 and DP2 disposed in the device region DR. In example embodiments, at least a portion of the interconnection pattern layer 125a may include rectangular interconnection patterns CP extending in the first direction D1, and at least a portion of the dummy pattern layer 125b may include a first dummy pattern DP1 and a second dummy pattern DP2 adjacent to the rectangular interconnection patterns CP in the first direction D1 and spaced apart from each other in the second direction D2.

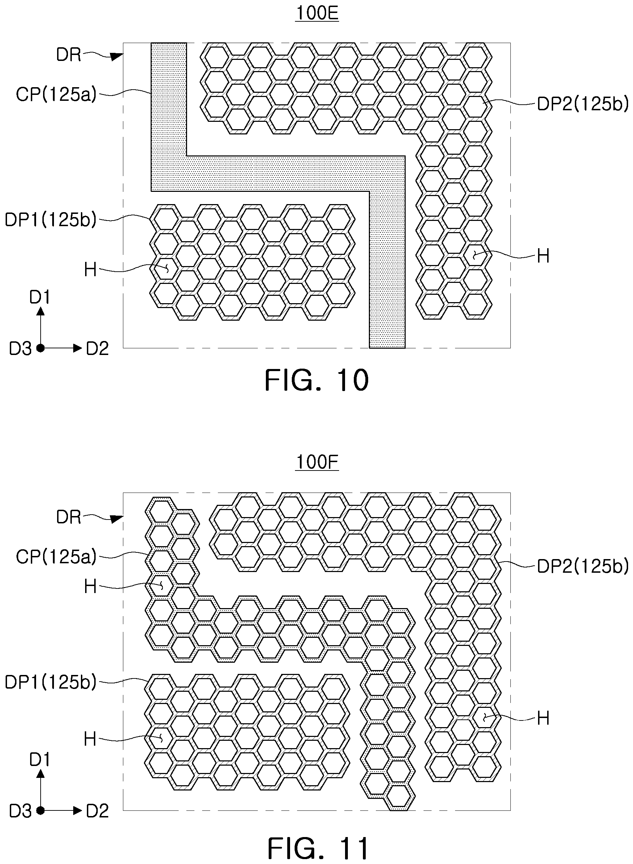

FIG. 10 is a plan view of an example of a partial region of a semiconductor device according to example embodiments. In FIG. 10, a semiconductor device 100E may include an interconnection pattern CP extending in the first direction D1 and the second direction D2 in the device region DR and at least one dummy pattern DP1 and DP2 adjacent to at least one side of the interconnection pattern CP. The dummy pattern layer 125b may include a first dummy pattern DP1 and a second dummy pattern DP2 occupying empty spaces on both sides of the interconnection pattern CP. At least one dummy pattern DP1 and DP2 may reduce undulation of the interlayer insulating layer 121a near the interconnection pattern CP.

FIG. 11 is a plan view of an example of a portion of a semiconductor device according to example embodiments. In FIG. 11, a semiconductor device 100F may include a mesh interconnection pattern CP and mesh dummy patterns DP1 and DP2. At least a portion of each of the interconnection pattern layers 125a and the dummy pattern layers 125b may include a mesh pattern. The through-holes H of the interconnection pattern CP and the through-holes H of the dummy patterns DP1 and DP2 may have substantially the same planar shape and size. According to example embodiments, only the interconnection pattern layers 125a may include a mesh pattern, and the dummy pattern layers 125b may not include a mesh pattern.

In example embodiments, the sizes of the through-holes H in the device region DR may be different. For example, the size (e.g., the maximum width, the planar area, and the like) of the through-holes formed in the interconnection pattern layers 125a (interconnection patterns located on a relatively lower level) requiring relatively fine line widths may be less than the sizes (e.g., the maximum width, the planar area, and the like) of the through-holes formed in other interconnection pattern layers 125a.

In addition, the through-holes H (e.g., the through-holes of the interconnection pattern layers 125a) in the device region DR and the through-holes (e.g., the through-holes of the blocking pattern layers 125c) in the edge region ER may have different sizes. For example, the size (e.g., the maximum width, the planar area, and the like) of the through-holes formed in the interconnection pattern layers 125a requiring relatively fine line widths may be less than the size (e.g., the maximum width, the planar area, and the like) of the through-holes formed in the blocking pattern layers 125c.

In some embodiments, the shape of through-holes in some components (e.g. through-holes of the interconnection pattern layers 125a) may differ from the shape of through-holes in other components (e.g. through-holes of the blocking pattern layers 125c, through-holes of the dummy pattern layers 125b, and/or through-holes of the guard ring structure 125d). Alternatively, the shape may be the same.

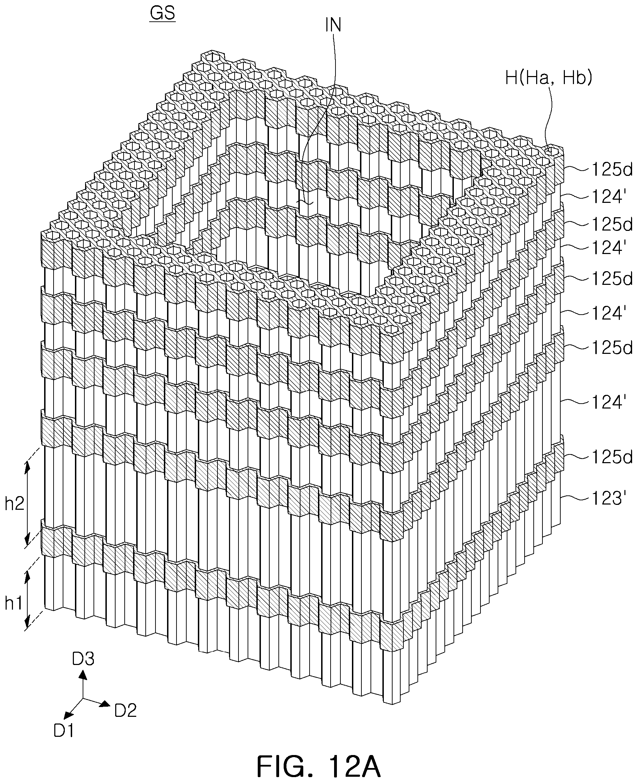

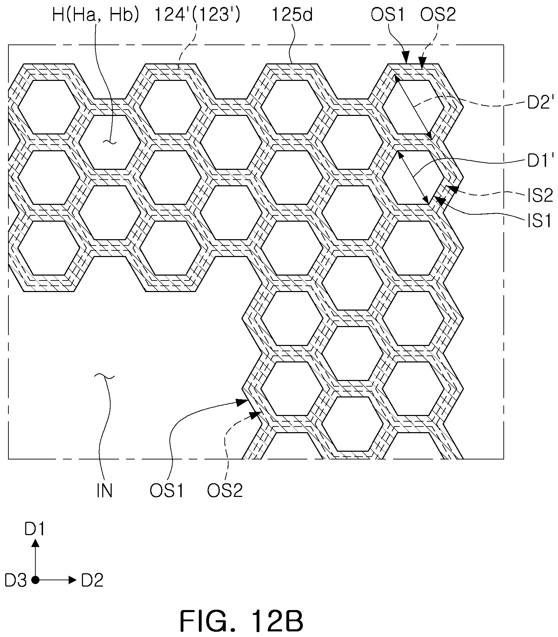

FIG. 12A is a perspective view illustrating a guard ring structure GS of an example embodiment, and FIG. 12B is a plan view of a portion of the guard ring structure of FIG. 12A.

Referring to FIGS. 12A and 12B, the guard ring structure GS of an example embodiment may include a plurality of guard ring pattern layers 125d, a plurality of guard ring via layers 124', and a dummy connection layer 123' stacked in the vertical direction. The plurality of guard ring pattern layers 125d and the plurality of guard ring via layers 124' may be alternately stacked in the vertical direction D3. The plurality of guard ring via layers 124' may be arranged between the plurality of guard ring pattern layers 125d. The dummy connection layer 123' may be disposed between the lowest guard ring pattern layer 125d among the plurality of guard ring pattern layers 125d and a semiconductor substrate.

The guard ring structure GS may define an internal space IN sealed in the horizontal directions D1 and D2. That is, the plurality of guard ring pattern layers 125d, the plurality of guard ring via layers 124', and the dummy connection layer 123' may each have a dam shape defining at least a region of the internal space IN sealed in the horizontal directions D1 and D2. As described above with reference to FIGS. 4A to 5F, the plurality of guard ring pattern layers 125d, the plurality of guard ring via layers 124', and the dummy connection layer 123' may be a mesh pattern having a plurality of through-holes H. The plurality of through-holes H may penetrate through the entirety of the plurality of guard ring pattern layers 125d, the plurality of guard ring via layers 124', and the dummy connection layer 123' in the vertical direction D3.

A height h1 of the dummy connection layer 123' and a height h2 of the plurality of guard ring via layers 124' may be different from each other. In addition, the height h2 of each of the plurality of guard ring via layers 124' may also be different from each other. The height h1 of the dummy connection layer 123' and the height h2 of the plurality of guard ring via layers 124' may correspond to a distance between the plurality of guard ring pattern layers 125d in the vertical direction D3.

Each of the plurality of guard ring pattern layers 125d may have a mesh structure in which a plurality of first through-holes Ha are repeated in the horizontal direction, and each of the plurality of guard ring via layers 124' may have a mesh structure in which a plurality of second through-holes Hb are repeated in the horizontal direction. In addition, the dummy connection layer 123' may have a mesh structure in which a plurality of third through-holes (identical to the second through-holes 'Hb') are repeated in the horizontal direction. Hereinafter, the plurality of second through-holes Hb may be understood as referring to both the through-holes in the dummy connection layer 123' and the through-holes of the plurality of guard ring via layers 124'. The plurality of first through-holes Ha and the plurality of second and third through-holes Hb may overlap in the vertical direction D3.

The plurality of guard ring pattern layers 125d may extend continuously along the perimeter of the plurality of first through-holes Ha, and the plurality of guard ring via layers 124' and the dummy connection layer 123' may extend continuously along the perimeter of the plurality of second through-holes Hb. Line widths of the plurality of guard ring via layers 124' and the dummy connection layer 123' may be equal to or smaller than a line width of the plurality of guard ring pattern layers 125d. For example, a gap between a second inner side surface IS2 and a second outer side surface OS2 (of guard ring via layers 124' and the dummy connection layer 123') may be equal to or smaller than a gap between a first inner side surface IS1 and a first outer side surface OS1 (of the guard ring pattern layers 125d).

According to an example embodiment, the first through-holes Ha in the plurality of guard ring pattern layers 125d and the second through-holes Hb in the plurality of guard ring via layers 124' and the dummy connection layer 123' may have the same or different sizes. For example, the maximum width D2' of the second through-holes Hb may be equal to or larger than the maximum width D1' of the first through-holes Ha. The maximum width of each of the plurality of first through-holes Ha and the plurality of second through-holes Hb may be about 1 µm or less (e.g. may be 1 µm or less).

The plurality of guard ring pattern layers 125d may have the first inner side surface IS 1 defining an inner wall of the first through-holes Ha and the first outer side surface OS1 opposite thereto. The plurality of guard ring via layers 124' and the dummy connection layer 123' may have the second inner side surface IS2 defining an inner wall of the second through-holes Hb and the second outer side surface OS2 opposite thereto. The first outer side surface OS1 may have a bent shape along the border of the first through-holes Ha arranged at an edge among the plurality of first through-holes Ha. The second outer side surface OS2 may have a bent shape along the border of the second through-holes Hb arranged at an edge among the plurality of second through-holes Hb.

The first inner side surface IS1 and the second inner side surface IS2 may not coincide with each other. In plan view, the second inner side surface IS2 may be located inside the plurality of guard ring pattern layers 125d. In addition, the first outer side surface OS1 and the second outer side surface OS2 may not coincide with each other, and in plan view, the second outer side surface OS2 may be located inside the plurality of guard ring pattern layers 125d. In some example embodiments, the first inner side surface IS1 and the second inner side surface IS2 may be coplanar with each other, and the first outer side surface OS1 and the second outer side surface OS2 may be coplanar with each other. In this case, the maximum width D1' of the first through-holes Ha and the maximum width D2' of the second through-holes Hb may be substantially the same.

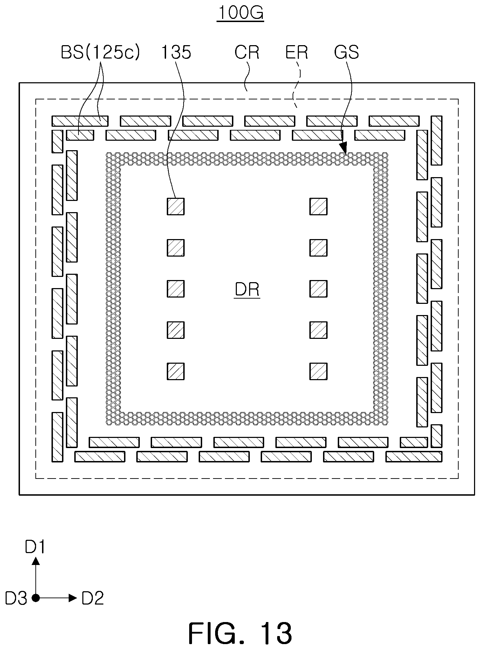

FIG. 13 is a plan view of a semiconductor device 100G according to an example embodiment.

Referring to FIG. 13, the semiconductor device 100G of an example embodiment may include a guard ring structure GS configured in a mesh pattern. The guard ring structure GS may be formed to completely surround the device region DR on a plane. The guard ring structure GS may be a structure stacked on the edge region ER in the vertical direction D3 to surround the device region DR. The guard ring structure GS may have a structure (which may be referred to as a `mesh structure') the same as or similar to that described above with reference to FIGS. 6A and 6B. That is, the device region DR may be disposed in the internal space of the guard ring structure GS described above with reference to FIGS. 12A and 12B, and the guard ring structure GS may be configured to seal the device region DR in the horizontal directions D1 and D2. In the drawing, the guard ring structure GS is illustrated as being a square, but is not limited thereto. In some example embodiments, the guard ring structure GS may have a circular or oval planar shape.

The crack blocking structure BS may include a plurality of blocking patterns 125c arranged on the outside of the guard ring structure GS. The plurality of blocking patterns 125c may be arranged to be staggered with respect to each other in the horizontal directions D1 and D2. The semiconductor device 100H may include a portion of the cut region CR remaining in the dicing process and surrounding the periphery of the crack blocking structure BS. For example, the blocking pattern layers 125c illustrated in FIGS. 3A and 3B may each include rectangular patterns extending from the outside of the guard ring structure GS.

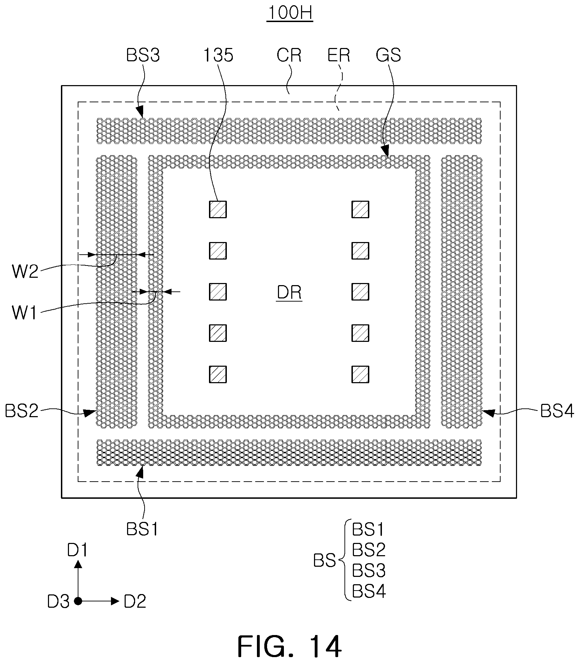

FIG. 14 is a plan view of a semiconductor device 100H according to an example embodiment. Referring to FIG. 14, the semiconductor device 100H of the example embodiment may have characteristics the same as or similar to those described above with reference to FIG. 13, except that the semiconductor device 100H includes both of the guard ring structure GS formed of a mesh pattern and the crack blocking structure BS formed of a mesh pattern. A plurality of blocking patterns BS1, BS2, BS3, and BS4 constituting the crack blocking structure BS may have the same or similar structure as the mesh patterns described above with reference to FIGS. 4A to 5F. The crack blocking structure BS may include a first blocking pattern BS1, a second blocking pattern BS2, a third blocking pattern BS3, and a fourth blocking pattern BS4 corresponding to the outer side surfaces of the guard ring structure GS, respectively. A planar shape of the crack blocking structure BS illustrated in the drawing may be understood as reflecting the planar shape of the blocking pattern layers 125c of FIGS. 3A and 3B. For example, each of the blocking pattern layers 125c may include a plurality of blocking patterns (e.g., BS1, BS2, BS3, and BS4) extending to surround at least a portion of the outer side of the guard ring structure GS in plan view.

The guard ring structure GS may include an inner side facing the device region DR and an outer side opposite the inner side of the guard ring structure GS and may have a first width W1 between the inner side and the outer side. The crack blocking structure BS may include an inner side facing the guard ring structure GS and an outer side opposite the inner side and may have a second width W2 between the inner side and the outer side. In an example embodiment, the first width W1 of the guard ring structure GS may be smaller than the second width W2 of the crack blocking structure BS.

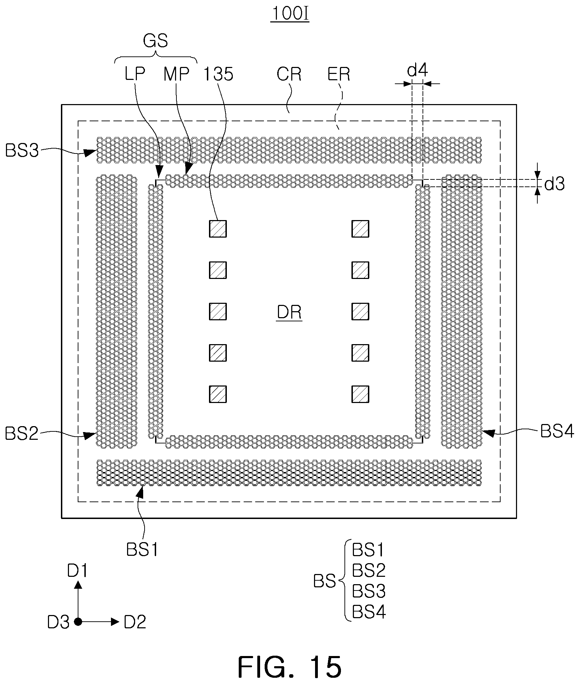

FIG. 15 is a plan view of a semiconductor device 100I according to an example embodiment.

Referring to FIG. 15, the semiconductor device 100I of the example embodiment may have characteristics the same as or similar to those described above with reference to FIGS. 13 and 14, except that the semiconductor device 100I includes a guard ring structure GS including mesh pattern portions MP and at least one line connection portion LP. The mesh pattern portions MP may have the same or similar structure as the mesh patterns described above with reference to FIGS. 4A to 5F. The line connection portion LP may be disposed between the mesh pattern portions MP spaced apart from each other. The line connection portion LP may extend in at least one direction between the mesh pattern portions MP. In order to maximize the crack blocking, moisture absorption prevention, and other effects of the guard ring structure GS, the guard ring structure GS may be designed to minimize the length of the line connection portion LP. For example, at least one line connection portion LP may extend by a first length d3 in the first horizontal direction and by a second length d4 in the second horizontal direction between the mesh pattern portions MP. Here, the first length D3 and the second length d4 may each be in the range of about 5 µm or less (e.g. of 5 µm or less), for example, about 0.1 µm to about 5 µm (e.g. of 0.1 µm to 5 µm), about 1 µm to about 5 µm (e.g. of 1 µm to 5 µm), about 2 µm to about 5 µm (e.g. of 2 µm to 5 µm), etc.

Since the line connection portion LP is disposed between the mesh pattern portions MP in which it is difficult to form a mesh pattern regularly, the line connection portion LP may improve a design freedom of the mesh pattern portions MP. For example, the line connection portion LP may be disposed at a corner portion of the guard ring structure GS (e.g. a corner portion of a quadrangular guard ring structure GS), but is not limited thereto.

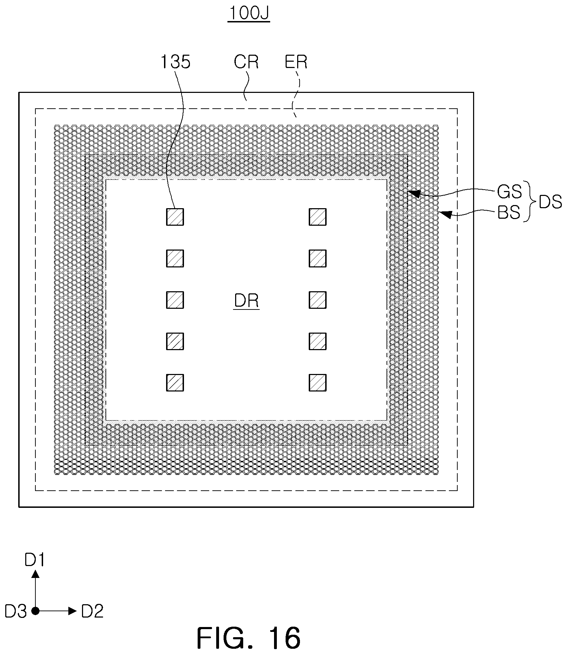

FIG. 16 is a plan view of a semiconductor device 100J according to an example embodiment.

Referring to FIG. 16, the semiconductor device 100J of an example embodiment may have characteristics the same as or similar to those described above with reference to FIGS. 13 to 15, except that the semiconductor device 100J includes a mesh dam structure DS in which the guard ring structure GS and the crack blocking structure BS are integrated. For example, the dam structure DS may be understood as a structure in which the mesh guard ring structure GS and the crack blocking structure BS are connected to each other in the horizontal direction(s). The dam structure DS may include a wide pattern layer in which the blocking pattern layers 125c and the guard ring pattern layers 125d illustrated in FIGS. 3A and 3B are integrated in the horizontal directions D1 and D2. In addition, the dam structure DS may further include a wide via layer in which the dummy connection layer 123' and/or the guard ring via layer 124 illustrated in FIGS. 3A and 3B extend to the blocking pattern layers 125c in the horizontal directions D1 and D2.

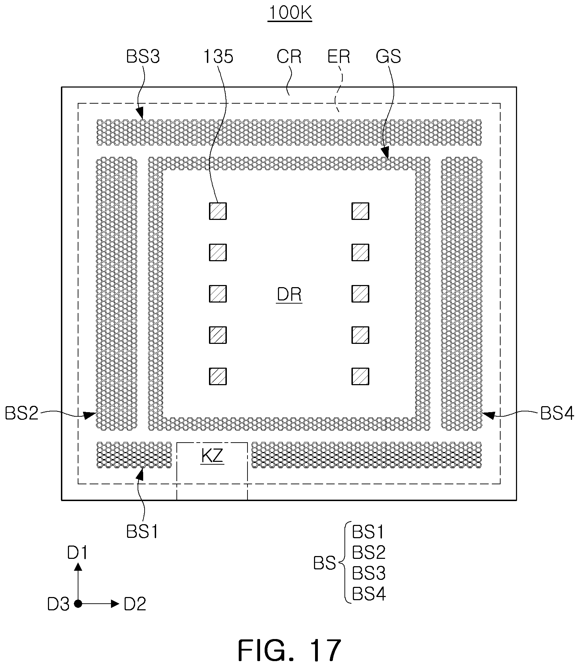

FIG. 17 is a plan view of a semiconductor device 100K according to an example embodiment.

Referring to FIG. 17, the semiconductor device 100K of the example embodiment may have characteristics the same as or similar to those described above with reference to FIGS. 13 to 16, except that the semiconductor device 100K includes an alignment key region KZ. The alignment key region KZ may be a region in which an alignment pattern for vertical alignment is formed. The alignment key region KZ may be disposed in an outer region of the device adjacent to the cut region CR, i.e., outside the guard ring structure GS. The alignment key region KZ may overlap at least a portion of the crack blocking structure BS. Within the alignment key region KZ, a pattern for blocking cracks, for example, blocking pattern layers, may not be formed. For example, the crack blocking structure BS may include mesh blocking patterns BS1, BS2, BS3, and BS4 respectively corresponding to the outer side surfaces of the guard ring structure GS. The alignment key region KZ may cut off a portion of at least one blocking pattern, for example, the first blocking pattern BS1.

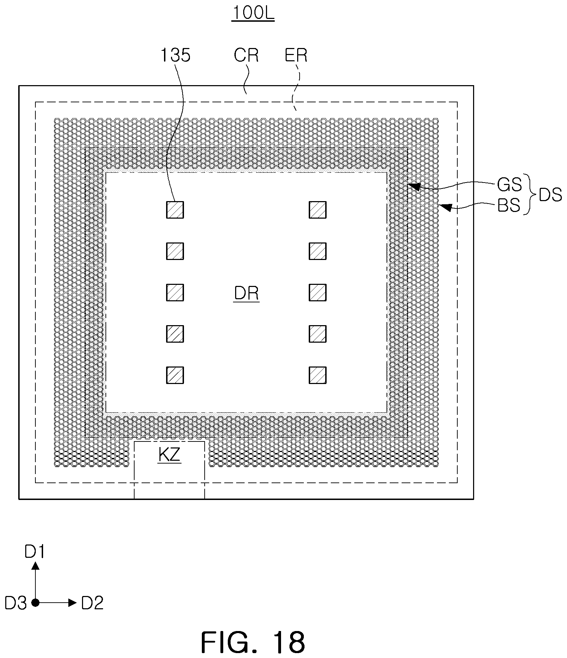

FIG. 18 is a plan view of a semiconductor device 100L according to an example embodiment.

The semiconductor device 100L of an example embodiment may have characteristics the same as or similar to those described above with reference to FIGS. 13 to 17, except that the semiconductor device 100L includes the mesh dam structure DS and the alignment key region KZ. The dam structure DS may include a mesh wide pattern layer in which the guard ring structure GS and the crack blocking structure BS are integrated. In an example embodiment, the alignment key region KZ may partially overlap the wide pattern layer of the dam structure DS. The dam structure DS may be formed to surround at least a portion of the alignment key region KZ. The dam structure DS may block a space between the alignment key region KZ and the element region DR. According to an example embodiment, the alignment key region KZ may extend up to a region overlapping the guard ring structure GS.

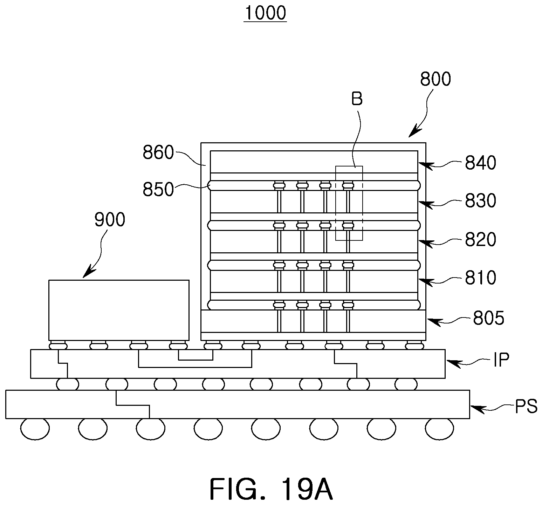

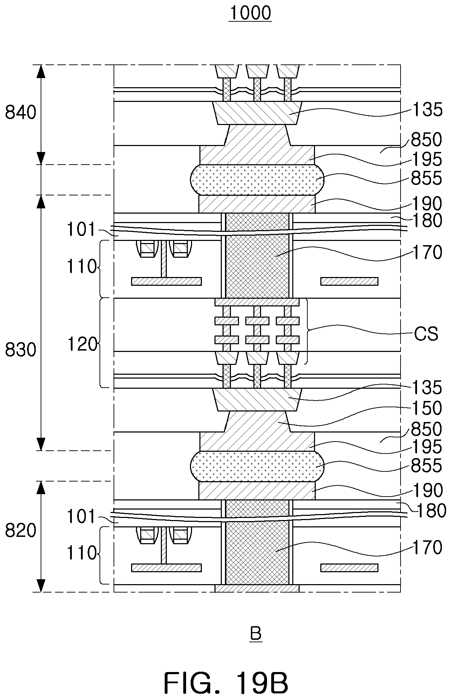

FIG. 19A is a cross-sectional view of an example of a semiconductor package including a semiconductor device according to example embodiments, and FIG. 19B is a partially enlarged view of an example of a region 'B' of FIG. 19A according to example embodiments. In FIGS. 19A and 19B, a semiconductor package 1000 may be a high bandwidth memory (HBM) package. The semiconductor package 1000 may include a package substrate PS, an interposer IP mounted on the package substrate PS, a memory package 800 and a processor chip 900 mounted on the interposer IP. The interposer IP may electrically connect the memory package 800 to the processor chip 900.

The memory package 800 may include a buffer chip 805, a first semiconductor device 810, a second semiconductor device 820, a third semiconductor device 830, and a fourth semiconductor device 840 which are sequentially stacked. The buffer chip 805 and the first to fourth semiconductor devices 810, 820, 830, and 840 may have a structure the same as or similar to that of the semiconductor device 100 described above with reference to FIGS. 1 to 18 and may include, for example, mesh pattern layers stacked in the device region DR and the edge region ER in the vertical direction.

The memory package 800 may further include a bump 855 between the second semiconductor device 820 and the third semiconductor device 830 and between the third semiconductor device 830 and the fourth semiconductor device 840. The first to fourth semiconductor devices 810, 820, 830, and 840 may further include a connection pad 195 connected to an upper conductive pattern 150. The connection pad 195 may fill the opening OP illustrated in FIG. 3B and may be in contact with the upper conductive pattern 135. The connection pad 195 may penetrate through the passivation layer 131. The bump 855 may connect a via pad 190 and a connection pad 195 between adjacent semiconductor devices 820, 830, and 840. An adhesive layer 850 may cover the sides of the via pad 190, the connection pad 195, and the bump 855. In an example embodiment, the bump 855 may be omitted, and the via pad 190 and connection pad 195 may be in direct contact with each other.

In example embodiments, the buffer chip 805 may be a different type of semiconductor chip from the first to fourth semiconductor devices 810, 820, 830, and 840. For example, the buffer chip 805 may be a logic chip, and the first to fourth semiconductor devices 810, 820, 830, and 840 may be memory chips. The logic chip may include a microprocessor, analog element, or digital signal processor. The memory chip may include a volatile memory chip, such as DRAM or SRAM, or a nonvolatile memory chip, such as PRAM, MRAM, FeRAM, or RRAM.

The memory package 800 may further include the adhesive layer 850 and an encapsulant 860. The adhesive layer 850 may be disposed between the buffer chip 805 and the first semiconductor device 810 and between the first to fourth semiconductor devices 810, 820, 830, and 840. The adhesive layer 850 may be non-conductive film (NCF) or non-conductive paste (NCP). The encapsulant 860 may be a resin including epoxy or polyimide. For example, the resin may include a bisphenol-group epoxy resin, a polycyclic aromatic epoxy resin, an o-cresol novolac epoxy resin, a biphenyl-group epoxy resin, or a naphthalene-group epoxy resin.

The processor chip 900 may be a central processing unit (CPU), a graphics processing unit (GPU), a mobile application, or a digital signal processor (DSP) chip.

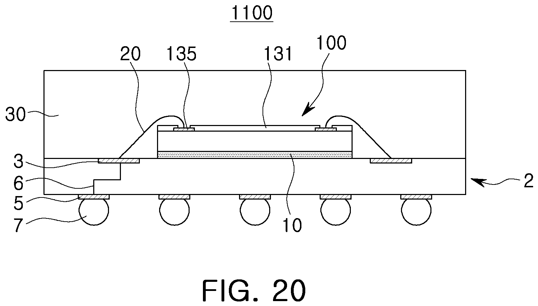

FIG. 20 is a cross-sectional view of an example of a semiconductor package including a semiconductor device according to example embodiments. In FIG. 20, a semiconductor package 1100 may include a substrate 2, an adhesive member 10, a bonding wire 20, and an encapsulant 30. The semiconductor package 1100 may also include a semiconductor device 100 on the substrate 2.

The substrate 2 may include upper pads 3, lower pads 5, an internal interconnection 6, and an external connection terminal 7. In example embodiments, the substrate 2 may be a printed circuit board and may include an insulating material, such as a phenolic resin, an epoxy resin, or prepreg. In another example embodiment, the substrate 2 may be a redistribution layer in which an insulating material and a conductive material are stacked. The upper pads 3 and lower pads 5 may be formed by forming a metal layer on a base of the substrate 2 and then patterning the metal layer.

The upper pads 3 may be disposed on an upper surface of the substrate 2 and may be electrically connected to the semiconductor device 100. The lower pads 5 may be disposed on a lower surface of the substrate 2, and the upper pads 3 may be electrically connected to the corresponding lower pads 5 by the internal interconnection 6. The external connection terminals 7 may be disposed below the lower pads 5. The lower pad 5, upper pad 3, and the interconnection may include metal, such as copper (Cu). The external connection terminal 7 may be, for example, a solder bump.

The semiconductor device 100 may be understood as having characteristics the same as or similar to those of the semiconductor device 100 described above with reference to FIGS. 1 to 18. The passivation layer 131 may protect the upper conductive pattern 135 from external physical shock. The upper conductive pattern 135 may be connected to the upper pad 3 by the bonding wire 20.

The adhesive member 10 may be disposed between the substrate 2 and the semiconductor device 100. The adhesive member 10 may fix the semiconductor device 100 on the substrate 2. The adhesive member 10 may be a die attach film (DAF), but is not limited thereto. The encapsulant 30 may cover the substrate 2, the semiconductor device 100, and the bonding wire 20.

According to example embodiments, the semiconductor device having improved reliability and the semiconductor package including the same may be provided by introducing the mesh patterns into the conductive pattern layer in the semiconductor device.

Embodiments are set out in the following Clauses:
Clause 1. A semiconductor device comprising:
   a semiconductor substrate including a device region and an edge region surrounding the device region;
   an interconnection structure including a plurality of conductive pattern layers stacked in a vertical direction on the device region;
   a guard ring structure extending in a horizontal direction and surrounding the interconnection structure within the edge region;
   a crack blocking structure disposed on an outside of the guard ring structure and including a plurality of blocking pattern layers stacked in the vertical direction;
   pad structures disposed on the interconnection structure and electrically connected to at least a portion of the plurality of conductive pattern layers; and
   a passivation layer disposed on the pad structures and including an opening exposing at least a portion of the pad structures,
   wherein each of the plurality of blocking pattern layers extends to surround at least a portion of an outside of the guard ring structure, and
   wherein each of the plurality of blocking pattern layers includes a plurality of first through-holes arranged in the horizontal direction and having substantially the same planar shape.
Clause 2. The semiconductor device of Clause 1, wherein the plurality of first through-holes of each of the plurality of blocking pattern layers overlap each other at least partially in the vertical direction.
Clause 3. The semiconductor device of Clause 1 or Clause 2, wherein the planar shape of the plurality of first through-holes includes a circle or a polygon.
Clause 4. The semiconductor device of any preceding Clause, wherein a spacing between the plurality of first through-holes adjacent to each other is equal to or less than a maximum width of each of the plurality of first through-holes.
Clause 5. The semiconductor device of Clause 4, wherein the maximum width of each of the plurality of first through-holes is about 1 µm or less.
Clause 6. The semiconductor device of any preceding Clause, wherein the plurality of blocking pattern layers includes at least one blocking pattern having the plurality of first through-holes and surrounding the outside of the guard ring structure on a plane.
Clause 7. The semiconductor device of any preceding Clause,
   wherein the plurality of conductive pattern layers includes interconnection pattern layers electrically connected to integrated circuit devices arranged on an active surface of the semiconductor substrate and dummy pattern layers electrically insulated from the interconnection pattern layers,
   wherein at least a portion of the interconnection pattern layers and the dummy pattern layers include a plurality of second through-holes arranged in the horizontal direction, and
   wherein the plurality of second through-holes have substantially the same planar shape.
Clause 8. The semiconductor device of Clause 7,
   wherein at least a portion of the interconnection pattern layers include rectangular interconnection patterns extending in a first direction within a plane,
   wherein at least a portion of the dummy pattern layers includes at least one dummy pattern adjacent to the rectangular interconnection patterns in the first direction, and
   wherein the portion of the dummy pattern layers have the plurality of second through-holes arranged in a second direction perpendicular to the first direction, within the plane.
Clause 9. The semiconductor device of Clause 8, wherein a line width of portions of the at least one dummy pattern defining the plurality of second through-holes is less than a length of the corresponding rectangular interconnection patterns in the first direction.
Clause 10. The semiconductor device of any of Clauses 7-9,
   wherein at least a portion of the interconnection pattern layers include interconnection patterns extending in a first direction and a second direction within the plane,
   wherein at least a portion of the dummy pattern layers includes at least one dummy pattern adjacent to at least one side of the interconnection patterns, and
   wherein the portion of the dummy pattern layers have the plurality of second through-holes.
Clause 11. The semiconductor device of any of Clauses 7-10, wherein at least a portion of the interconnection pattern layers and at least a portion of the dummy pattern layers each include mesh patterns having the plurality of second through-holes.
Clause 12. The semiconductor device of any of Clauses 7-11, wherein a maximum width of each of the plurality of second through-holes is equal to or less than a maximum width of each of the plurality of first through-holes.
Clause 13. The semiconductor device of any of Clauses 7-12, wherein the plurality of second through-holes are spaced apart from each other in the vertical direction and have different sizes.
Clause 14. The semiconductor device of any preceding Clause, wherein the guard ring structure includes a plurality of guard ring pattern layers stacked in the vertical direction.
Clause 15. A semiconductor device comprising:
   a semiconductor substrate including a device region and an edge region surrounding the device region;
   a plurality of conductive pattern layers stacked in a vertical direction on the device region;
   a guard ring structure extending in a horizontal direction an surrounding the device region; and
   a plurality of blocking pattern layers stacked in the vertical direction and disposed on the edge region around the guard ring structure,
   wherein at least a portion of the plurality of conductive pattern layers and the plurality of blocking pattern layers are adjacent to each other in the vertical direction, and
   wherein the portion of the plurality of conductive pattern layers includes mesh pattern layers each having a plurality of through-holes.
Clause 16. The semiconductor device of Clause 15, wherein the through-holes arranged in the horizontal direction, among the plurality of through-holes, have substantially the same planar shape and substantially the same planar area.
Clause 17. The semiconductor device of Clause 15 or Clause 16, wherein a planar shape of each of the plurality of through-holes includes a circle or polygon.
Clause 18. The semiconductor device of any of Clauses 15-17,
   wherein the plurality of conductive pattern layers includes interconnection pattern layers electrically connected to integrated circuit devices disposed on the device region and dummy pattern layers electrically insulated from the interconnection pattern layers, and
   wherein at least a portion of each of the interconnection pattern layers and the dummy pattern layers includes the mesh pattern layers.
Clause 19. A semiconductor device comprising:
   a semiconductor substrate including a device region in which integrated circuit devices are disposed and an edge region surrounding the device region;
   a plurality of interconnection pattern layers stacked in a vertical direction on the device region and electrically connected to the integrated circuit devices;
   a plurality of dummy pattern layers stacked in the vertical direction on the device region and electrically insulated from the plurality of interconnection pattern layers; and
   a plurality of crack blocking pattern layers stacked in the vertical direction on the edge region and extending in a horizontal direction to surround the device region,
   wherein each of the plurality of crack blocking pattern layers is a mesh pattern including a plurality of first through-holes, and
   wherein at least a portion of the plurality of interconnection pattern layers includes mesh patterns having a plurality of second through-holes.
Clause 20. The semiconductor device of Clause 19, wherein the plurality of first through-holes and the plurality of second through-holes have substantially the same planar shape.
Clause 21. The semiconductor device of Clause 19 or Clause 20, wherein the plurality of first through-holes and the plurality of second through-holes located on the same vertical level have the same size.
Clause 22. The semiconductor device of Clause 19 or Clause 20, wherein the plurality of first through-holes and the plurality of second through-holes located on the same vertical level have different sizes.
Clause 23. The semiconductor device of Clause 22, wherein a size of the plurality of second through-holes is less than a size of the plurality of first through-holes.
Clause 24. The semiconductor device of any of Clauses 19-23, further comprising vias electrically connecting the plurality of interconnection pattern layers to each other.
Clause 25. The semiconductor device of any of Clauses 19-24, wherein the plurality of crack blocking pattern layers are electrically insulated from each other.
Clause 26. A semiconductor device comprising:
   a semiconductor substrate including a device region and an edge region surrounding the device region;
   an interconnection structure including a plurality of conductive pattern layers stacked in a vertical direction on the device region;
   a guard ring structure including a plurality of guard ring pattern layers and a plurality of guard ring via layers alternately stacked in the vertical direction on the edge region and surrounding the device region; and
   pad structures disposed on the interconnection structure and electrically connected to at least a portion of the plurality of conductive pattern layers,
   wherein each of the plurality of guard ring pattern layers has a mesh structure in which a plurality of first through-holes are repeated in a horizontal direction,
   each of the plurality of guard ring via layers has a mesh structure in which a plurality of second through-holes are repeated in the horizontal direction, and
   the plurality of first through-holes and the plurality of second through-holes overlap in the vertical direction.
Clause 27. The semiconductor device of Clause 26, wherein the guard ring structure further includes a dummy connection layer disposed between a lowermost guard ring pattern layer among the plurality of guard ring pattern layers and the semiconductor substrate, and the dummy connection layer has a mesh structure in which a plurality of third through-holes are repeated in the horizontal direction.
Clause 28. The semiconductor device of Clause 27, wherein the plurality of third through-holes overlap the plurality of first through-holes and the plurality of second through-holes in the vertical direction.
Clause 29. The semiconductor device of any of Clauses 26-28, wherein the plurality of guard ring pattern layers include a first inner side surface defining an inner wall of the plurality of first through-holes and a first outer side surface bent along a border of the first through-holes arranged at an edge among the plurality of first through-holes, and
   wherein the plurality of guard ring via layers include a second inner side surface defining an inner wall of the plurality of second through-holes and a second outer side surface bent along a border of the second through-holes arranged at an edge among the plurality of second through-holes.
Clause 30. The semiconductor device of Clause 29, wherein a gap between the second inner side surface and the second outer side surface is equal to or smaller than a gap between the first inner side surface and the first outer side surface.
Clause 31. The semiconductor device of any of Clauses 26-30, wherein a maximum width of each of the plurality of second through-holes is equal to or greater than a maximum width of each of the plurality of first through-holes.
Clause 32. The semiconductor device of any of Clauses 26-31, wherein the plurality of guard ring pattern layers extend continuously along a perimeter of the plurality of first through-holes, and the plurality of guard ring via layers extend continuously along a perimeter of the plurality of second through-holes.
Clause 33. The semiconductor device of any of Clauses 26-32, wherein the plurality of first through-holes and the plurality of second through-holes have a circular or polygonal plane shape.
Clause 34. The semiconductor device of any of Clauses 26-33, wherein a maximum width of each of the plurality of first through-holes and the plurality of second through-holes is about 1 µm or less.
Clause 35. The semiconductor device of any of Clauses 26-34, wherein the plurality of guard ring pattern layers include mesh pattern portions including the plurality of first through-holes and at least one line connection portion connecting the mesh pattern portions to each other.
Clause 36. The semiconductor device of Clause 35, wherein the at least one line connection portion extends by a first length and in a first horizontal direction and by a second length in a second horizontal direction between the mesh pattern portions.
Clause 37. The semiconductor device of Clause 36, wherein the first length and the second length are each about 5 µm or less.
Clause 38. A semiconductor device comprising:
   a semiconductor substrate including a device region and an edge region surrounding the device region;
   an interconnection structure including a plurality of conductive pattern layers vertically stacked in a vertical direction on the device region;
   a guard ring structure including a plurality of guard ring pattern layers stacked on the edge region in the vertical direction and surrounding the device region;
   a crack blocking structure disposed on an outer side of the guard ring structure and including a plurality of blocking pattern layers stacked in the vertical direction;
   pad structures disposed on the interconnection structure and electrically connected to at least a portion of the plurality of conductive pattern layers; and
   a passivation layer disposed on the pad structures and including an opening exposing at least a portion of the pad structures,
   wherein the plurality of guard ring pattern layers and the plurality of blocking pattern layers are each a mesh pattern.
Clause 39. The semiconductor device of Clause 38, wherein the plurality of blocking pattern layers each surround continuously or discontinuously the outer side of the guard ring structure on a plane.
Clause 40. The semiconductor device of Clause 38 or Clause 39, wherein the plurality of guard ring pattern layers each surround continuously a perimeter of the device region on a plane.
Clause 41. The semiconductor device of any of Clauses 38-40, wherein the guard ring structure has an inner side facing the device region and an outer side opposite to the inner side of the guard ring structure,
   the crack blocking structure has an inner side facing the guard ring structure and an outer side opposite to the inner side of the crack blocking structure, and
   a width between the inner side and the outer side of the guard ring structure is smaller than a width between the inner side and the outer side of the crack blocking structure.
Clause 42. The semiconductor device of any of Clauses 38-41, wherein the plurality of guard ring pattern layers and the plurality of blocking pattern layers are connected to each other in a horizontal direction.
Clause 43. The semiconductor device of any of Clauses 38-42, further comprising an alignment key region disposed on the outer side of the guard ring structure, in which the plurality of blocking pattern layers are not arranged.
Clause 44. A semiconductor device comprising:
   a semiconductor substrate including a device region and an edge region surrounding the device region;
   an interconnection structure including a plurality of conductive pattern layers stacked in a vertical direction on the device region;
   a guard ring structure including a plurality of guard ring pattern layers stacked in the vertical direction on the edge region and surrounding the device region, a plurality of guard ring via layers between the plurality of guard ring pattern layers, and a dummy connection layer interposed between the plurality of guard ring pattern layers and the semiconductor substrate;
   a crack blocking structure surrounding at least a portion of an outer side of the guard ring structure;
   pad structures disposed on the interconnection structure and electrically connected to at least a portion of the plurality of conductive pattern layers; and
   a passivation layer disposed on the pad structures and including an opening exposing at least a portion of the pad structures,
   wherein the guard ring structure includes a plurality of through-holes penetrating through an entirety of the plurality of guard ring pattern layers, the plurality of guard ring via layers, and the dummy connection layer.
Clause 45. The semiconductor device of Clause 44, wherein the guard ring structure defines an internal space sealed in a horizontal direction, and the device region is located within the internal space.

While this disclosure contains many specific embodiment details, these should not be construed as limitations on the scope of what may be claimed. Certain features that are described in this disclosure in the context of separate embodiments can also be implemented in combination in a single embodiment. Conversely, various features that are described in the context of a single implementation can also be implemented in multiple embodiments separately or in any suitable subcombination. Moreover, although features may be described above as acting in certain combinations, one or more features from a combination can in some cases be excised from the combination, and the combination may be directed to a subcombination or variation of a subcombination.

## Claims

1. A semiconductor device comprising:
a semiconductor substrate including a device region and an edge region surrounding the device region;
an interconnection structure including a plurality of conductive pattern layers stacked in a vertical direction on the device region;
a guard ring structure extending in a horizontal direction and surrounding the interconnection structure within the edge region;
a crack blocking structure disposed on an outside of the guard ring structure and including a plurality of blocking pattern layers stacked in the vertical direction;
pad structures disposed on the interconnection structure and electrically connected to at least a portion of the plurality of conductive pattern layers; and
a passivation layer disposed on the pad structures and including an opening exposing at least a portion of the pad structures,
wherein each of the plurality of blocking pattern layers extends to surround at least a portion of an outside of the guard ring structure, and
wherein each of the plurality of blocking pattern layers includes a plurality of first through-holes arranged in the horizontal direction and having substantially the same planar shape.

2. The semiconductor device of claim 1, wherein the plurality of first through-holes of each of the plurality of blocking pattern layers overlap each other at least partially in the vertical direction.

3. The semiconductor device of claim 1 or claim 2, wherein the planar shape of the plurality of first through-holes includes a circle or a polygon.

4. The semiconductor device of any preceding claim, wherein a spacing between the plurality of first through-holes adjacent to each other is equal to or less than a maximum width of each of the plurality of first through-holes.

5. The semiconductor device of claim 4, wherein the maximum width of each of the plurality of first through-holes is about 1 µm or less.

6. The semiconductor device of any preceding claim, wherein the plurality of blocking pattern layers includes at least one blocking pattern having the plurality of first through-holes and surrounding the outside of the guard ring structure on a plane.

7. The semiconductor device of any preceding claim,
wherein the plurality of conductive pattern layers includes interconnection pattern layers electrically connected to integrated circuit devices arranged on an active surface of the semiconductor substrate and dummy pattern layers electrically insulated from the interconnection pattern layers,
wherein at least a portion of the interconnection pattern layers and the dummy pattern layers include a plurality of second through-holes arranged in the horizontal direction, and
wherein the plurality of second through-holes have substantially the same planar shape.

8. The semiconductor device of claim 7,
wherein at least a portion of the interconnection pattern layers include rectangular interconnection patterns extending in a first direction within a plane,
wherein at least a portion of the dummy pattern layers includes at least one dummy pattern adjacent to the rectangular interconnection patterns in the first direction, and
wherein the portion of the dummy pattern layers have the plurality of second through-holes arranged in a second direction perpendicular to the first direction, within the plane.

9. The semiconductor device of claim 8, wherein a line width of portions of the at least one dummy pattern defining the plurality of second through-holes is less than a length of the corresponding rectangular interconnection patterns in the first direction.

10. The semiconductor device of any of claims 7-9,
wherein at least a portion of the interconnection pattern layers include interconnection patterns extending in a first direction and a second direction within the plane,
wherein at least a portion of the dummy pattern layers includes at least one dummy pattern adjacent to at least one side of the interconnection patterns, and
wherein the portion of the dummy pattern layers have the plurality of second through-holes.

11. The semiconductor device of any of claims 7-10, wherein at least a portion of the interconnection pattern layers and at least a portion of the dummy pattern layers each include mesh patterns having the plurality of second through-holes.

12. The semiconductor device of any preceding claim, wherein the guard ring structure includes a plurality of guard ring pattern layers and a plurality of guard ring via layers alternately stacked in the vertical direction on the edge region, and
wherein the plurality of guard ring pattern layers and the plurality of guard ring via layers surround the device region.

13. The semiconductor device of claim 12, wherein each of the plurality of guard ring pattern layers has a mesh structure in which a plurality of third through-holes are repeated in the horizontal direction, and
wherein each of the plurality of guard ring via layers has a mesh structure in which a plurality of fourth through-holes are repeated in the horizontal direction.

14. The semiconductor device of claim 13, wherein the plurality of third through-holes and the plurality of fourth through-holes overlap in the vertical direction.

15. The semiconductor device of claim 13 or claim 14, wherein the guard ring structure further includes a dummy connection layer disposed between a lowermost guard ring pattern layer among the plurality of guard ring pattern layers and the semiconductor substrate, and
wherein the dummy connection layer has a mesh structure in which a plurality of fifth through-holes are repeated in the horizontal direction.
